# EUROPÄISCHE PATENTSCHRIFT

(11) **EP 0 622 902 B1**
(45) Veröffentlichungstag und Bekanntmachung des Hinweises auf die Patenterteilung: **28.01.1998**
(21) Anmeldenummer: 93113942.2
(22) Anmeldetag: 01.09.1993
(51) Int. Cl.: H03K 17/16, H03K 17/13, H03K 17/79

(54) **Halbleiterrelais**
Solid-state relay
Relais semi-conducteur

(30) Priorität: 28.04.1993 DE 4313882
(43) Veröffentlichungstag der Anmeldung: 02.11.1994
(73) Patentinhaber: Carlo Gavazzi AG, CH-6312 Steinhausen (CH)
(72) Erfinder: Kristensen, Ove Stym, c/o Electromatic Industri AS, DK-8370 Hadsten (DK); Helbo, Jan, c/o Electromatic Industri AS, DK-8370 Hadsten (DK)
(74) Vertreter: Kehl, Günther, Dipl.-Phys.

(56) Entgegenhaltungen:
- EP-A- 0 245 769
- EP-A- 0 272 898
- US-A- 3 959 668
- US-A- 4 258 276

## Beschreibung

Die Erfindung bezieht sich auf ein Halbleiterrelais zum Schalten einer Wechselstrom last mit mindestens einem Steuereingang zur Aufnahme eines Steuersignals, mit mindestens zwei Lastausgangsanschlüssen und mit mindestens einem bidirektionalen Halbleiterlastschalter, der zwischen die beiden Lastausgangsanschlüsse geschaltet ist, entsprechend dem Steuersignal ansteuerbar ist und zu dem eine schaltbare Bypassleitung parallel angeordnet ist.

Herkömmliche Halbleiterrelais dieser Art verwenden gewöhnlich als Lastschalter einen TRIAC, zwei Leistungsthyristoren oder einen anderen bidirektionalen Halbleiterlastschalter. Derartige Halbleiterlastschalter führen, nachdem sie gezündet worden sind, solange Strom, wie an ihren Anschlüssen eine zur Aufrechterhaltung des Stromflusses ausreichende Spannung aufrechterhalten wird. Nähert sich jedoch die Wechselstromspannung dem Wert Null, erlöscht der TRIAC oder Leistungsthyristor, und der Stromfluß fällt in diesem Moment abrupt auf den Wert Null. Nach dem erneuten Ansteigen der Wechselspannung (in entgegengesetzter Richtung) muß der bidirektionale Halbleiterlastschalter erneut gezündet werden. Da Voraussetzung für die Zündung das Bestehen einer Mindestspannung von meistens ca. 5 Volt ist, erfolgt hier wiederum ein abrupter Stromanstieg. Um nun diese abrupten Stromänderungen, das heißt große Stromdifferentialwerte dl/dt sowie dadurch hervorgerufene elektromagnetische Emissionsstörungen zu vermeiden, ist bei Halbleiterrelais nach dem Stand der Technik parallel zum bidirektionalen Halbleiterlastschalter eine schaltbare Bypassleitung angeordnet, durch die sichergestellt ist, daß auch dann der Stromfluß durch die Last aufrechterhalten wird, wenn die am bidirektionalen Halbleiterlastschalter anliegende Spannung den Schwellenwert für die Aufrechterhaltung des Stroms im bidirektionalen Halbleiterlastschalter unterschreitet. Der Laststrom wird in diesem Fall ausschließlich über die Bypassleitung geführt. Da die Spannung an den Ausgangsanschlüssen sehr klein ist, ist der Laststrom entsprechend klein und kann von Transistoren getragen werden. Durch die Schaltbarkeit der Bypassleitung ist sichergestellt, daß die Bypassleitung dann unterbrochen werden kann, wenn kein Steuersignal am Steuereingang anliegt und sich das Relais in seinem AUS-Zustand befindet.

Aus der Europäischen Patentanmeldung EP 0 245 769 A1 ist ein derartiges gattungsbildendes Halbleiterrelais bekannt, bei dem parallel zu einem als bidirektionaler Halbleiterlastschalter wirkenden TRIAC eine schaltbare Bypassleitung angeordnet ist.

Eine Parallelschaltung eines TRIAC-Schaltelements und eines Relaiskontakts ist auch in der deutschen Patentschrift DE 36 22 093 C1 vorgesehen, wobei in dieser Druckschrift jedoch erwähnt wird, daß die Zuschaltung des Relaiskontakts um einige Netzvollwellen verzögert gegenüber der Zündung des TRIAC-Schaltelements erfolgt.

Aus der deutschen Patentschrift DE 35 11 207 A1 ist eine Lastschalteinrichtung bekannt, die einen mit seiner Schaltstrecke parallel zur Schaltstrecke des Thyristors geschalteten Transistor umfaßt, wobei der Transistor Lastströme, die unterhalb des Haltestroms des Thyristors liegen, durchschaltet und wobei an dem Transistor bei oberhalb des Thyristorstroms liegendem Laststrom ein Zündsignal für den Thyristor gewonnen wird.

Schließlich sei der Vollständigkeit halber noch die Druckschrift "Elektor", Nr. 7, 1983 erwähnt, bei der unter dem Stichwort LED-"Verstärker" auf Seite 98 exemplarisch ausgeführt wird, wie drei Transistoren dafür sorgen, daß ein TRIAC nur dicht beim Nulldurchgang gezündet werden kann, so daß Netzstörungen weitgehend vermieden werden. Wird die Spannung in der positiven Halbwelle größer als etwa 7 Volt, so schaltet einer der drei Transistoren durch und leitet den Strom so um, daß kein Gatestrom mehr an den TRIAC geliefert werden kann. In der negativen Halbwelle geschieht prinzipiell das Gleiche, nur schalten hier die anderen beiden Transistoren durch, wenn die Spannung Werte von -7 Volt betragsmäßig überschreitet.

Allen nach dem Stand der Technik bekannten Halbleiterrelais ist jedoch das Problem gemeinsam, daß das in der Bypassleitung enthaltene Schaltelement bzw. die dort enthaltenen Schaltelemente bei Erreichen von Spitzenlastspannungen nicht vor den entsprechenden Strömen geschützt werden können, so daß eine Fehlfunktion oder gar Zerstörung des bzw. der in der Bypassleitung enthaltenen Schaltelemente nicht ausgeschlossen werden kann.

Ausgehend hiervon liegt der Erfindung die Aufgabe zugrunde, bekannte Halbleiterrelais derart zu verbessern, daß das bzw. die in der Bypassleitung enthaltenen Schaltelemente vor durch hohe Lastspannungen hervorgerufenen großen Strömen bewahrt werden.

Erfindungsgemäß wird diese Aufgabe bei einem Halbleiterrelais der eingangs genannten Art dadurch gelöst, daß Schwellenwertdetektormittel vorgesehen sind, durch die die Bypassleitung nur dann durchgeschaltet wird, wenn der Momentanwert einer an den Ausgangsanschlüssen anliegenden Wechselspannung kleiner als ein bestimmter positiver Schwellenwert und größer als ein bestimmter negativer Schwellenwert ist.

Durch das Vorsehen der Schwellenwertdetektormittel ist sichergestellt, daß die Bypassleitung nur in einem Zeitintervall aktiv wird, in dem die Wechselspannungsphase einen Nulldurchgang aufweist. Während der Zeiten großer Lastspannungen ist die Bypassleitung somit inaktiv. Das in der Bypassleitung enthaltene Schaltelement oder die dort enthaltenen Schaltelemente werden dann vor den entsprechend großen Strömen, die bei Erreichen der Spitzenspannung auftreten, bewahrt.

Nach einer vorteilhaften Ausführungsform der Erfindung ist vorgesehen, daß in der zur Steuerelektrode des bidirektionalen Halbleiterlastschalters führenden Zuleitung ein Schaltelement angeordnet ist, das in gleicher Weise wie die Bypassleitung schaltbar ist. Insbesondere wenn eine Schwellenwertdetektorschaltung der oben beschriebenen Art vorgesehen ist, kann durch diesen Schaltungsaufbau erreicht werden, daß während der Nulldurchgangszeit Strom in die Zündelektrode des bidirektionalen Halbleiterlastschalters injiziert wird, so daß dieser so früh wie möglich nach Durchlaufen der Nullspannung gezündet wird. Andererseits ist das Zünden des bidirektionalen Halbleiterlastschalters außerhalb der Nulldurchgangsintervalle nicht möglich, da die Zuleitung zur Zündelektrode gesperrt ist. Auf diese Weise werden elektromagnetische Emissionsstörungen, die auf das "Triggern" oder Zünden des bidirektionalen Halbleiterlastschalters zurückzuführen sind, vermieden.

Vorzugsweise enthält die Bypassleitung zwei in Serie geschaltete

Metalloxidfeldeffekttransistoren (MOSFETs), deren Gateanschlüsse miteinander verbunden sind. Zwei in Serie geschaltete MOSFETs können vorteilhafterweise auch als Schaltelement in der zur Steuerelektrode des bidirektionalen Halbleiterlastschalters führenden Zuleitung verwendet werden.

Um eine gleiche Ansteuerung der Transistoren in der Bypassleitung und der Transistoren in der zur Zündelektrode des bidirektionalen Halbleiterlastschalters führenden Zuleitung zu erreichen, können die Gateelektroden aller MOSFETs verbunden sein.

Als bidirektionaler Halbleiterlastschalter wird vorzugsweise ein TRIAC verwendet.

Nach einer bevorzugten Ausführungsform der Erfindung ist an die Steuereingänge ein Optokoppler angeschlossen, der ausgangsseitig eine Solarzelle aufweist, die bei Anliegen eines Steuersignals am Eingang eine Ausgangsspannung liefert, die zur Ansteuerung der Schaltelemente in der Bypassleitung und in der Zuleitung dient. Durch die Verwendung eines Optokopplers wird eine vollständige galvanische Trennung zwischen dem Steuereingang und dem Lastausgang erreicht.

Nach einer anderen vorteilhaften Ausführungsform sind die Steuereingänge mit der Primärwicklung eines Transformators verbunden, dessen Sekundärwicklung das Steuersignal für die Schaltmittel in der Bypassleitung und der Zuleitung liefert. Auch hier ist eine galvanische Entkoppelung möglich. Zur Erregung des Halbleiterrelais ist jedoch eine Wechselspannung erforderlich.

Nach einer weiteren vorteilhaften Ausführungsform der Erfindung ist als Schwellenwertdetektormittel ein Transistor vorgesehen, dessen Emitter und Kollektor mit den Ausgangsanschlüssen des Optokopplers verbunden sind. Wenn der Transistor durchschaltet, werden somit die Ausgangsanschlüsse des Optokopplers kurzgeschlossen und die Entstehung einer Ansteuerspannung vermieden. Die Ansteuerung des als Schwellenwertdetektor dienenden Transistors erfolgt in der Weise, daß ein zwischen seiner Basis und seinen Emitter geschalteter Widerstand von einem pulsierenden Gleichstrom durchflossen wird, der aus der Lastspannung durch eine Gleichrichterschaltung gewonnen wird. Durch entsprechende Dimensionierung der Stärke des pulsierenden Gleichstroms und des Basisemitterwiderstandes kann erreicht werden, daß der Transistor genau dann in den leitenden Zustand schaltet, wenn der Absolutwert der Lastspannung einen bestimmten Wert überschreitet. Dagegen sperrt der Transistor in einem Zeitintervall, das symmetrisch zum Nulldurchgangspunkt der Lastspannung liegt.

Die Erfindung wird im folgenden an Hand des in den Figuren 1 bis 3 schematisch dargestellten Ausführungsbeispieles näher erläutert. Es zeigt:
- Figur 1:: Ein Blockschaltbild eines Halbleiterrelais gemäß der Erfindung.
- Figur 2:: Ein Schaubild zur Verdeutlichung des ausgangsseitigen Spannungsverlaufes.
- Figur 3:: Ein Schaubild zur Verdeutlichung des Stromverlaufes im Lastkreis.

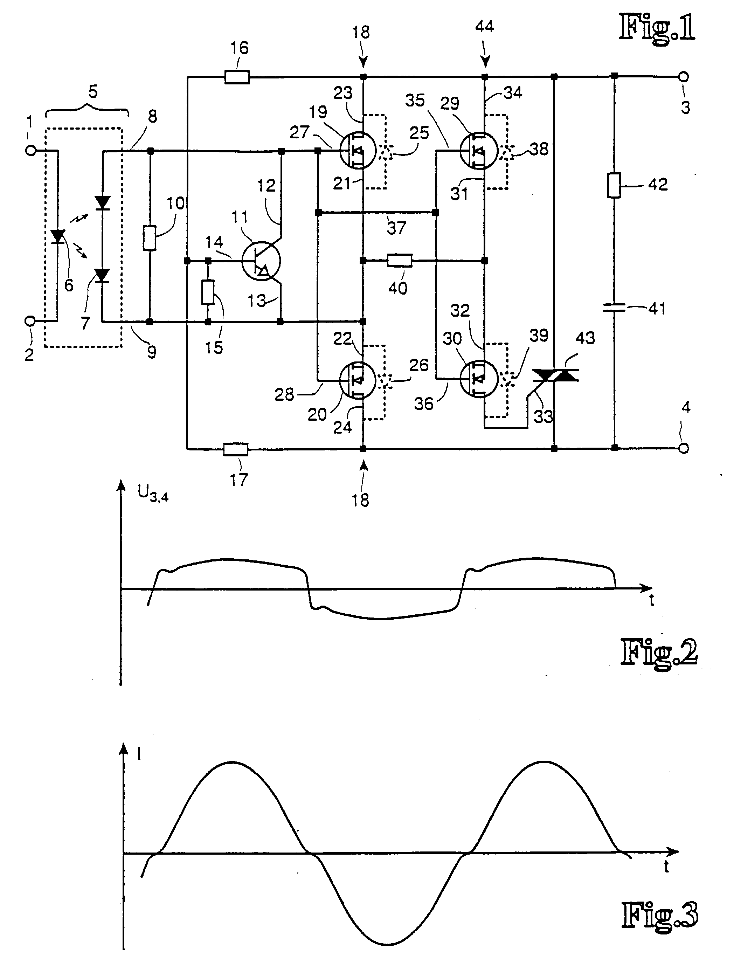

Das Halbleiterrelais gemäß Figur 1 weist zwei Eingangsanschlüsse 1 und 2 auf, an die üblicherweise ein Steuersignal angelegt wird. Die Eingangsanschlüsse 1 und 2 entsprechen den Anschlüssen der Spulenwicklung bei einem Magnetrelais. Das Relais weist des weiteren zwei Ausgangsanschlüsse 3 und 4 auf, an die eine Wechselspannungsquelle sowie eine Last (nicht dargestellt) anzuschließen sind. Wenn an den Anschlüssen 1 und 2 ein Steuersignal anliegt, soll durch das Relais eine niederohmige Verbindung zwischen den Anschlüssen 3 und 4 hergestellt werden, sodaß ein Wechselstrom über den Lastkreis fließen kann.

Die Anschlüsse 1 und 2 sind mit dem Eingang eines Optokopplers 5 verbunden. Der Optokoppler 5 enthält eine Lumineszenzdiode 6 sowie eine Solarzelle 7, die bei Bestrahlung durch Licht von der Lumineszenzdiode 6 eine Spannung an den Ausgängen 8 und 9 des Optokopplers 5 liefert.

Anstelle eines Optokopplers könnte auch eine induktive Kopplung unter Verwendung eines Transformators vorgesehen werden.

Die beiden Ausgänge 8 und 9 des Optokopplers 5 sind über einen Widerstand 10 miteinander verbunden. Parallel zum Widerstand 10 ist ein Transistor 11 geschaltet, dessen Kollektor 12 mit dem positiven Ausgang 8 der Solarzelle 7 und dessen Emitter 13 mit dem negativen Ausgang 9 der Solarzelle 7 verbunden ist. Die Basis 14 des Transistors 11 ist über einen Widerstand 15 mit dem Emitter 13 verbunden. Die Basis 14 ist des weiteren mit dem Mittelpunkt eines Spannungsteilers verbunden, der aus zwei Widerständen 16 und 17 besteht, und die mit ihrem jeweiligen zweiten Ende mit den Ausgangsanschlüssen 3 und 4 in Verbindung stehen.

Die Ausgangsanschlüsse 3 und 4 sind desweiteren über eine Bypassleitung 18 verbunden, die zwei in Serie geschaltete n-Kanal-Enhancement-Mosfets 19 und 20 enthält. Die Mosfets 19 und 20 sind so geschaltet, daß ihre jeweiligen Sourceanschlüsse 21 und 22 miteinander verbunden sind, während ihre Drainanschlüsse 23 bzw. 24 direkt mit den Ausgangsanschlüssen 3 bzw. 4 verbunden sind. Die Substratelektrode eines jeden Mosfets ist mit seinem jeweiligen Sourceanschluß verbunden, sodaß sich funktionsmäßig jeweils eine interne Diode 25 bzw. 26 ergibt, die entgegengesetzt gerichtet sind. Die Gateanschlüsse 27 und 28 der beiden Mosfets 19 bzw. 20 sind miteinander verbunden und gemeinsam an den positiven Ausgang 8 des Optokopplers 5 angeschlossen.

Parallel zu der Bypassleitung 18 ist zwischen die Ausgangsanschlüsse 3 und 4 ein TRIAC 43 als bidirektionaler Halbleiterlastschalter geschaltet. Die Zündelektrode 33 des TRIACS 43 ist über eine Zuleitung 44 mit dem Ausgangsanschluß 3 verbunden. In der Zuleitung 44 sind zwei n-Kanal-Enhancement-Mosfets 29, 30 derart in Serie geschaltet, daß ihre Sourceelektroden 31 bzw. 32 miteinander in Verbindung stehen, während der Drainanschluß des Mosfets 30 direkt mit der Zündelektrode 33 des TRIACS 43 verbunden ist und der Drainanschluß 34 des Mosfets 29 in direktem Kontakt mit dem Ausgangsanschluß 3 steht. Die Gateanschlüsse 35 und 36 der Mosfets 29 und 30 sind gemeinsam über eine Verbindungsleitung 37 mit den Gateanschlüssen 27 und 28 der Mosfets 19 und 20 verbunden. Die Substratanschlüsse der Mosfets 29 bzw. 30 sind jeweils mit ihren Sourceanschlüssen 31 bzw. 32 verbunden, sodaß sich jeweils eine interne Diode 38 bzw. 39 ergibt, die in der Zeichnung strichliert gezeichnet ist. Die Dioden weisen wiederum in entgegengesetzte Richtung, d.h. ihre Leitfähigkeitrichtungen sind entgegengesetzt.

Der Verbindungspunkt der Sourceanschlüsse 21 und 22 der Mosfets 19 und 20 ist mit dem Verbindungspunkt der Sourceanschlüsse 31 und 32 der Mosfets 29 und 30 über einen Widerstand 40 verbunden.

Die Anschlüsse 3 und 4 sind desweiteren über einen Kodensator 41 und einen zu diesem in Serie geschalteten Widerstand 42 überbrückt.

Das Halbleiterrelais arbeitet wie folgt:

Wenn am Steuereingang 1, 2 keine Spannung anliegt, sind auch die Ausgangsanschlüsse 8 und 9 des Optokopplers 5 spannungsfrei, sodaß die miteinander verbundenen Gateanschlüsse 27, 28, 35 und 36 der Mosfets 19, 20, 29 und 30 auf dem gleichen Potential liegen, wie der Anschluß 8 des Optokopplers 5. Auch die Sourcelektroden 21, 22, 31 und 32 der Mosfets 19, 20, 29 und 30 sind untereinander verbunden und stehen mit dem Ausgangsanschluß 9 des Optokopplers in Verbindung. Da zwischen den Ausgangsanschlüssen 8 und 9 keine Spannung liegt, sind somit die Gate/Source-Spannungen aller Mosfets 19, 20, 29 und 30 gleich Null. Da es sich um Enhancement-Mosfets handelt sind wenigstens diejenigen Mosfets gesperrt, deren interne Diode in Sperrrichtung liegt. Da die internen Dioden 25 und 26 der Mosfets 19 und 20 in der Bypassleitung 18 jeweils entgegengesetzt gepolt sind, ist - gleichgültig in welcher Richtung die Wechselspannung an den Polen 3 und 4 anliegt - mindestens einer der beiden Mosfets 19 und 20 gesperrt, sodaß über die Bypassleitung 18 kein Strom fließen kann.

Das gleiche gilt für die Zuleitung 44 zur Zündelektrode 33 des TRIACS 43. Auch hier ist auf Grund der gleichen Schaltung mindestens einer der beiden Mosfets 29 oder 30 gesperrt, sodaß sowohl während der positiven als auch während der negativen Halbwellen der Wechselspannung sowohl die Bypassleitung 18 als auch die Zuleitung 44 gesperrt sind. Das bedeutet, daß der TRIAC 43 nicht zündet und daß er auch nicht durch die Bypassleitung 18 überbrückt wird. Der Ausgang 3, 4 ist daher im hochohmigen Zustand, d.h. das Relais ist ausgeschaltet und es kann kein nennenswerter Strom im Lastkreis (nicht dargestellt) fließen.

Wenn nun an den Eingangsanschlüssen 1 und 2 des Optokopplers 5 ein Steuersignal anliegt, sendet die Lumineszenzdiode 6 Licht aus, sodaß an den Ausgangsanschlüssen 8 und 9 der Solarzelle 7 eine Spannung erzeugt wird.

Vorausgesetzt, daß der Transistor 11 sperrt, gelangt das positive Potential des Ausgangsanschlusses 8 an die miteinander verbundenen Gateanschlüsse 27, 28, 35 und 36 und das negative Potential des Ausgangsanschlusses 9 an die Sourceanschlüsse 21 und 22 der Mosfets 19 und 20 sowie über den Widerstand 40 an die Sourceanschlüsse 31 und 32 der Mosfets 29 und 30. Die Mosfets werden durch die positive Gate/Source-Spannung in den leitenden Zustand geschaltet. Dies führt dazu, daß über die Zuleitung 44 und die Mosfets 29 und 30 Strom in die Zündelektrode 33 des TRIACS 43 injiziert wird, sodaß der TRIAC 43 zündet und die Ausgangsanschlüsse 3 und 4 kurzschließt, sodaß ein Wechselstrom über den Lastkreis fließen kann. Gleichzeitig kann in diesem Fall über die Bypassleitung 18, die parallel zu dem TRIAC 43 geschaltet ist, ein Teil des Laststromes fließen.

Wenn jedoch der Transistor 11 leitend ist, werden die Ausgangsanschlüsse 8 und 9 der Solarzelle 7 kurzgeschlossen, sodaß die Mosfets 19, 20, 29 und 30 keine Gate/Source-Spannung erhalten und sperren und folglich sowohl die Bypassleitung 18 als auch die Zuleitung 44 blockiert sind, obwohl eine Spannung an den Steuereingängen 1 und 2 anliegt.

Wegen der oben beschriebenen Schaltung des Transistors 11 gerät dieser stets dann in den leitenden Zustand, wenn die an den Ausgangsanschlüssen 3 und 4 anliegende Lastspannung einen bestimmten Absolutwert übersteigt. Mit anderen Worten, der Transistor 11 wird gesperrt, wenn die an den Ausgangsanschlüssen 3 und 4 anliegende Wechselspannung sich der Nulllinie entweder von der positiven Seite oder von der negativen Seite her nähert. Das bedeutet, der Transistor 11 ist leitend in einem Zeitintervall, das etwa symmetrisch zu jedem Spannungsnulldurchgang liegt. Falls beispielsweise der Anschluß 3 auf einem höheren Potential als der Anschluß 4 liegt, fließt Strom vom Anschluß 3 über den Widerstand 16 zum Widerstand 15 und von diesem über die interne Diode 26 des Mosfets 20 zum Ausgangsanschluß 4. Der aus den Widerständen 15 und 16 bestehende Spannungsteiler bewirkt, daß die Basis 14 des Transistors 11 gegenüber dem Emitter 13 positiv ist, sodaß der Transistor 11 in den leitenden Zustand schaltet. Falls der Ausgangsanschluß 3 auf einem tieferen Potential als der Ausgangsanschluß 4 liegt, fließt vom Ausgangsanschluß 4 ein Strom über den Widerstand 17, den Widerstand 15 und die interne Diode 25 des Mosfets 19 zum Ausgangsanschluß 3. Auch bei diesem Stromfluß ist die Basis 14 des Transistors 11 gegenüber seinem Emitter 13 positiv, sodaß der Transistor 11 leitend ist.

Lediglich wenn die Spannung zwischen den Punkten 3 und 4 sich dem Wert Null nähert (gleichgültig aus welcher Richtung) reicht der Spannungsabfall des über den Widerstand 15 fließenden Stromes nicht mehr aus, um den Transistor 11 durchzuschalten, sodaß dieser in den Sperrzustand übergeht und die Ausgangsspannung der Solarzelle aufrechterhalten bleibt. Da somit infolge der aufrechterhaltenen Spannung an den Anschlüssen 8 und 9 die Bypassleitung 18 und die Zuleitung 44 nur in einem Zeitraum im Bereich des Nulldurchgangs der Wechselspannung durchgeschaltet werden, fließt über die Bypassleitung 18 nur in diesem Zeitraum ein Strom.

Der Transistor 11 wirkt somit als Schwellenwertdetektor, der in den Sperrzustand schaltet, wenn der Momentanwert einer an den Ausgangsanschlüssen 3, 4 anliegenden Wechselspannung in einem vorgegebenen Intervall um die Nullspannung liegt. Nur in diesem Zustand ist die Durchschaltung der Bypassleitung 18 möglich, da nur in diesem Zustand die positive Steuerspannung an die Gateelektroden der Mosfets 19 und 20 gelangt.

Der TRIAC 43 kann folglich nur im Zeitpunkt des Nulldurchgangs der Wechselspannung gezündet werden. Ab dem Moment des Nulldurchganges der Wechselspannung steht über die Zuleitung 44 der Zündstrom zur Verfügung, sodaß die Zündung des TRIACS 43 sofort einsetzt, sobald die Spannung an den Ausgangsanschlüssen 3 und 4 einen für die Zündung des TRIACs ausreichenden Wert annimmt. Eine plötzliche Stromänderung wird daher vermieden. Vielmehr steigt der Strom infolge der frühzeitigen, nahe am Nulldurchgang der Spannung liegenden Zeitpunkt gleichmäßig an, sodaß keine störenden elektromagnetische Emissionen erzeugt werden.

Bekanntlich kann der TRIAC 43 nur solange Strom führen, wie die an seinen Anschlüssen anliegende Spannung über einem gewissen Grenzwert von ca. 5 Volt liegt. Fällt die Spannung unter diesen Wert ab, wird der TRIAC gelöscht und muß bei Ansteigen der Spannung erneut gezündet werden. Bei herkömmlichen Halbleiterrelais führt dieses Aus- und Einschalten bei jedem Spannungsnulldurchgang zu der Erzeugung von elektromagnetische Emissionsstörungen bei jedem Nulldurchgang der Wechselspannung.

Da bei dem erfindungsgemäßen Halbleiterrelais parallel zu dem TRIAC 43 eine Bypassleitung 18 geschaltet ist, die während der Nulldurchgangsphase der Wechselspannung sich in ihrem Leitzustand befindet, wird der Laststrom während des Phasennulldurchganges von der Bypassleitung 18 übernommen.

Die abrupten Stromänderungen, die bei herkömmlichen Halbleiterrelais durch das ständige Zünden und Erlöschen des TRIACS hervorgerufen werden, und die dadurch erzeugten Emissionsstörungen werden daher bei dem Halbleiterrelais gemäß der Erfindung vermieden.

Figur 2 zeigt den zeitlichen Spannungsverlauf an den Ausgangsanschlüssen 3 und 4, wenn zwischen diese eine Wechselspannung und dazu in Serie eine Last geschaltet wird. Wie aus Figur 2 zu entnehmen ist, steigt die Spannung nach dem Phasennulldurchgang verhältnismäßig steil an, da in diesem Moment die Spannung noch nicht ausreicht, um den TRIAC 43 zu zünden. Der Strom fließt vielmehr über die Mosfets 19 und 20 der Bypassleitung 18, die einen im Vergleich zu dem TRIAC 43 großen Widerstand aufweist. In diesem Zeitpunkt ist jedoch bereits die Zündelektrode über die Zuleitung 44 an den Ausgangsanschluß 3 angeschlossen, sodaß der TRIAC 43 sofort zünden kann, wenn die an den Anschlüssen 3 und 4 anliegende Lastspannung dies ermöglicht. Durch das Zünden des TRIACS 43 fällt die Spannung an den Anschlüssen 3 und 4 etwas ab und bleibt nach einem geringfügigen Anstieg etwa auf dem gleichen Niveau bestehen, da der TRIAC einen sehr geringen Eigenwiderstand aufweist. Wenn die Wechselspannung an den Anschlüssen 3 und 4 sich dem Nulldurchgang nähert, erlöscht der TRIAC 43. Dies führt jedoch nicht zu einem abrupten Spannungsanstieg, wie er bei Halbleiterrelais nach dem Stand der Technik zu beobachten ist. Vielmehr ist zu diesem Zeitpunkt der Transistor 11 bereits in den Sperrzustand übergegangen, sodaß durch das von dem Optokoppler 5 kommende Steuersignal die Transistoren 19 und 20 durchgeschaltet werden und die Stromleitung übernehmen. Eine große Spannungsänderung dU/dt, die zu elektromagnetischen Störungen führen würde, wird daher vermieden. Sobald die Spannung U_{3,4} einen entsprechenden Wert in der Gegenrichtung erreicht, der ausreicht, um den Stromfluß durch den TRIAC 43 aufrechtzuerhalten, wird dieser wiederum gezündet, sodaß sich das Wechselspiel wiederholt.

Figur 3 zeigt den Stromverlauf im Lastkreis als Funktion der Zeit. Wie zu erkennen ist, ist die Kurve in dem Bereich des Nulldurchganges besonders flach, d.h. der Wert dl/dt ist besonders klein, sodaß elektromagnetische Emissionsstörungen vermieden werden. Die Stromkurve ist kontinuierlich und weist - im Gegensatz zum Stand der Technik - keine Abbruchstellen auf, an denen der Strom abrupt auf den Wert Null fällt oder abrupt von Null auf einen bestimmten Wert ansteigt.

## Patentansprüche

1. Halbleiterrelais zum Schalten einer Wechselstromlast mit mindestens einem Steuereingang (1, 2) zur Aufnahme eines Steuersignals, mit mindestens zwei Lastausgangsanschlüssen (3, 4) und mit mindestens einem bidirektionalen Halbleiterlastschalter (43), der zwischen die beiden Lastausgangsanschlüsse (3, 4) geschaltet ist, entsprechend dem Steuersignal ansteuerbar ist und zu dem eine schaltbare Bypassleitung (18) parallel angeordnet ist, **dadurch gekennzeichnet**, daß Schwellenwertdetektormittel (11) vorgesehen sind, durch die die Bypassleitung (18) nur dann durchgeschaltet wird, wenn der Momentanwert einer an den Ausgangsanschlüssen (3, 4) anliegenden Wechselspannung kleiner als ein bestimmter positiver Schwellenwert und größer als ein bestimmter negativer Schwellenwert ist.

2. Halbleiterrelais nach Anspruch 1, dadurch gekennzeichnet, daß in der zur Steuerelektrode (33) des bidirektionalen Halbleiterlastschalters (43) führenden Zuleitung (44) ein Schaltelement (29, 30) angeordnet ist, das in gleicher Weise wie die Bypassleitung (18) schaltbar ist.

3. Halbleiterrelais nach Anspruch 1 oder 2, dadurch gekennzeichnet, daß die Bypassleitung (18) zwei in Serie geschaltete Metalloxidfeldeffekttransistoren (19, 20) enthält, deren Gateanschlüsse (27, 28) miteinander verbunden sind.

4. Halbleiterrelais nach Anspruch 2, dadurch gekennzeichnet, daß das Schaltelement aus zwei in Serie geschalteten Metalloxidfeldeffekttransistoren (29, 30) besteht, deren Gateanschlüsse (35, 36) miteinander verbunden sind.

5. Halbleiterrelais nach den Ansprüchen 3 und 4, dadurch gekennzeichnet, daß die Gateanschlüsse (27, 28) der Metalloxidfeldeffekttransistoren (19, 20) der Bypassleitung (18) mit den Gateanschlüssen (35, 36) der Metalloxidfeldeffekttransistoren (29, 30) der zur Steuerelektrode (33) des bidirektionalen Halbleiterlastschalters (43) führenden Zuleitung (44) miteinander verbunden sind.

6. Halbleiterrelais nach einem der Ansprüche 1 bis 5, dadurch gekennzeichnet, daß der bidirektionale Halbleiterlastschalter (43) ein TRIAC ist.

7. Halbleiterrelais nach einem der Ansprüche 1 bis 6, dadurch gekennzeichnet, daß der Steuereingang (1, 2) mit einem Optokoppler (5) verbunden ist.

8. Halbleiterrelais nach Anspruch 7, dadurch gekennzeichnet, daß der Optokoppler (5) ausgangsseitig eine Solarzelle (7) aufweist.

9. Halbleiterrelais nach einem der Ansprüche 1 bis 6, dadurch gekennzeichnet, daß der Steuereingang (1, 2) mit der Primärwicklung eines Transformators verbunden ist.

10. Halbleiterrelais nach den Ansprüchen 1 und 7, dadurch gekennzeichnet, daß die Schwellenwertdetektormittel einen Transistor (11) aufweisen, dessen Kollektor (12) bzw. Emitter (13) mit den Ausgangsanschlüssen (8) bzw. (9) des Optokopplers (5) verbunden sind.

11. Halbleiterrelais nach Anspruch 10, dadurch gekennzeichnet, daß ein Ausgangsanschluß (8) des Optokopplers (5) mit allen Gateanschlüssen (27, 28, 35, 36) der Metalloxidfeldeffekttransistoren (19, 20, 29, 30) verbunden ist.

## Claims

1. A semiconductor relay for switching an a.c. load having at least one control input (1, 2) for the reception of a control signal, at least two load output terminals (3, 4), and at least one bidirectional semiconductor load switch (43) which is connected between the two load output terminals (3, 4), can be actuated in accordance with the control signal, and in parallel to which a switchable bypass line (18) is arranged, characterised in that threshold value detector means (11) are provided by which the bypass line (18) is switched-through only when the instantaneous value of an a.c. voltage applied to the output terminals (3, 4) is smaller than a specified positive threshold value and greater than a specified negative threshold value.

2. A semiconductor relay according to Claim 1, characterised in that in the supply line (44) leading to the control electrode (33) of the bidirectional semiconductor load switch (43) there is arranged a switching element (29, 30) which can be switched in the same manner as the bypass line (18).

3. A semiconductor relay according to Claim 1 or 2, characterised in that the bypass line (18) comprises two series-connected metal oxide field effect transistors (19, 20) whose gate terminals (27, 28) are connected to one another.

4. A semiconductor relay according to Claim 2, characterised in that the switching element comprises two series-connected metal oxide field effect transistors (29, 30) whose gate terminals (35, 36) are connected to one another.

5. A semiconductor relay according to Claims 3 and 4, characterised in that the gate terminals (27, 28) of the metal oxide field effect transistors (19, 20) of the bypass line (18) are connected to the gate terminals (35, 36) of the metal oxide field effect transistors (29, 30) of the supply line (44) leading to the control electrode (33) of the bidirectional semiconductor load switch (43).

6. A semiconductor relay according to one of Claims 1 to 5, characterised in that the bidirectional semiconductor load switch (43) is a TRIAC.

7. A semiconductor relay according to one of Claims 1 to 6, characterised in that the control input (1, 2) is connected to an optocoupler (5).

8. A semiconductor relay according to Claim 7, characterised in that the optocoupler (5) has a solar cell (7) at its output end.

9. A semiconductor relay according to one of Claims 1 to 6, characterised in that the control input (1, 2) is connected to the primary winding of a transformer.

10. A semiconductor relay according to Claims 1 and 7, characterised in that the threshold value detector means comprise a transistor (11) whose collector (12) and emitter (13) are connected to the output terminals (8) and (9) respectively of the optocoupler (5).

11. A semiconductor relay according to Claim 10, characterised in that an output terminal (8) of the optocoupler (5) is connected to all the gate terminals (27, 28, 35, 36) of the metal oxide field effect transistors (19, 20, 29, 30).

## Revendications

1. Relais à semi-conducteurs de commutation d'une charge en courant alternatif, comprenant au moins une entrée de commande (1, 2) destinée à recevoir un signal de commande, au moins deux connexions de sortie à une charge (3, 4) ainsi qu'au moins un rupteur bidirectionnel à semi-conducteurs (43) qui est monté entre les deux connexions de sortie à une charge (3, 4), qui peut être attaqué en fonction du signal de commande et en parallèle auquel est monté un conducteur commutable en dérivation (18), caractérisé en ce que des moyens détecteurs de seuil (11) qui sont prévus ne commutent le conducteur en dérivation (18) que lorsque la valeur momentanée d'une tension alternative à laquelle sont les connexions de sortie (3, 4) est inférieure à un seuil positif déterminé et supérieure à un seuil négatif déterminé.

2. Relais à semi-conducteurs selon la revendication 1, caractérisé en ce qu'un élément de commutation (29, 30), qui est commutable de la même manière que le conducteur en dérivation (18), est monté dans le conducteur (44) d'arrivée à l'électrode de commande (33) du rupteur bidirectionnel à semi-conducteurs (43).

3. Relais à semi-conducteurs selon la revendication 1 ou 2, caractérisé en ce que le conducteur en dérivation (18) comprend deux transistors à effet de champ à oxyde métallique (19, 20) qui sont montés en série et dont les connexions à la grille (27, 28) sont raccordées l'une à l'autre.

4. Relais à semi-conducteurs selon la revendication 2, caractérisé en ce que l'élément de commutation consiste en deux transistors à effet de champ à oxyde métallique (29, 30) qui sont montés en série et dont les connexions (35, 36) à la grille sont raccordées l'une à l'autre.

5. Relais à semi-conducteurs selon les revendications 3 et 4, caractérisé en ce que les connexions (27, 28) à la grille des transistors à effet de champ à oxyde métallique (19, 20) du conducteur en dérivation (18) sont connectées aux connexions (35, 36) à la grille des transistors à effet de champ à oxyde métallique (29, 30) du conducteur (44) d'arrivée à l'électrode de commande (33) du rupteur bidirectionnel à semi-conducteurs (43).

6. Relais à semi-conducteurs selon l'une des revendications 1 à 5, caractérisé en ce que le rupteur bidirectionnel à semi-conducteurs (43) est un TRIAC.

7. Relais à semi-conducteurs selon l'une des revendications 1 à 6, caractérisé en ce que l'entrée de commande (1, 2) est connectée à un opto-coupleur (5).

8. Relais à semi-conducteurs selon la revendication 7, caractérisé en ce que l'opto-coupleur (5) comporte à la sortie une cellule solaire (7).

9. Relais à semi-conducteurs selon l'une des revendications 1 à 6, caractérisé en ce que l'entrée de commande (1, 2) est connectée au bobinage primaire d'un transformateur.

10. Relais à semi-conducteurs selon les revendications 1 et 7, caractérisé en ce que les moyens détecteurs de seuil comprennent un transistor (11) dont le collecteur (12) et l'émetteur (13) sont connectés aux connexions de sortie (8) ainsi que (9) de l'opto-coupleur (5).

11. Relais à semi-conducteurs selon la revendication 10, caractérisé en ce qu'une connexion de sortie (8) de l'opto-coupleur (5) est connectée à toutes les connexions (27, 28, 35, 36) à la grille des transistors à effet de champ à oxyde métallique (19, 20, 29, 30).
